Europäisches Patentamt

European Patent Office

Office européen des brevets

(11) Publication number: **0 384 946**
**A2**

## (12) EUROPEAN PATENT APPLICATION

(21) Application number: 89109866.7

(51) Int. Cl.⁵: **H01L 39/24, C04B 35/00**

(22) Date of filing: **31.05.89**

(30) Priority: **27.02.89 JP 45697/89**

(43) Date of publication of application:
**05.09.90 Bulletin 90/36**

(84) Designated Contracting States:
**DE FR GB**

(71) Applicant: **Mitsubishi Metal Corporation**
**5-2, Otemachi 1-chome Chiyoda-ku**
**Tokyo(JP)**

(72) Inventor: **Hagino, Sadaaki**
**7-203, 33-8, Harayama 2-chome**
**Urawa-shi Saitama-ken(JP)**
Inventor: **Suzuki, Motokazu**
**1135-4, Shima-cho**
**Omiya-shi Saitama-ken(JP)**
Inventor: **Takeshita, Takuo**
**149-404, Kishikicho 3-chome**
**Omiya-shi Saitama-ken(JP)**

(74) Representative: **Andrae, Steffen, Dr. et al**
**Patentanwälte Andrae, Flach, Haug, Kneissl**
**Steinstrasse 44**
**D-8000 München 80(DE)**

(54) **Process for fabricating superconducting ceramic materials.**

(57) A R-A-Cu-O based superconducting ceramic is fabricated as follows. First, a starting powder is provided and molded to form a molded body. Subsequently, the molded body is sintered in an oxygen atmosphere, at a predetermined temperature for a predetermined retention time to thereby obtain a sintered molded body or a ceramic. Then, the ceramic is cooled at a cooling rate satisfying a relation expressed by the equation:

$$\frac{\Delta T}{\Delta t} = k \cdot T \cdot \sqrt{P_{O_2}}$$

$(0.8 \leq k \leq 1.0)$

wherein T indicates the temperature (°C) of the sintered molded body during said cooling,

t indicates cooling period (hours),

$P_{O_2}$ indicates the partial pressure of oxygen (atm) during cooling

in a high temperature region at a temperature not lower than 300 °C after sintering. The ceramic having high critical temperature, high critical current value, and critical magnetic field is obtained.

FIGURE 1

EP 0 384 946 A2

**PROCESS FOR FABRICATING SUPERCONDUCTING CERAMIC MATERIALS**

FIELD OF THE INVENTION

The present invention relates to a process for fabricating superconducting ceramic materials comprising a yttrium-including rare earth element from the group including yttrium, an alkaline earth metal, and copper oxide (hereinafter referred to as "R-A-Cu-O based ceramic") which has a high theoretical density ratio, a high critical current value, and a high critical magnetic field.

BACKGROUND OF THE INVENTION

Conventional processes for fabricating worked materials such as wire rods, plates, strings, coils, and ribbons made of an R-A-Cu-O based superconducting ceramic include a process in which starting powders, i.e., an $R_2O_3$ powder, an alkaline earth metal carbonate powder, and CuO powder, each having an average grain size of not greater than 10 mm are provided and compounded in a predetermined compounding ratio followed by mixing to obtain a mixed powder, which is then calcined, e.g., in the air or in an oxygen atmosphere of 1 atm, at a temperature of from 930 °C to 950 °C for a retention time of 5 hours to form a ceramic material having a composition of $YBa_2Cu_3O_7$ and having a perovskite structure, for example. The ceramic is then ground to obtain powder of an average grain size of from 0.4 $\mu$m to 10 $\mu$m and a molding force of 1 to 2 ton/cm$^2$ is applied to obtain a molded body. The molded body is then sintered in an electric furnace in air at 1 atm, at a temperature of from 900 °C to 950 °C for a retention time of 12 hours and then cooled in the furnace and heat-treated in an oxygen flow of 1 atm, at a temperature of from 500 °C to 600 °C for a retention time of from 2 to 5 hours to obtain a superconducting ceramic material having a composition substantially the same as that of the ceramic described above.

It is known that molded bodies sintered in air have a tetragonal crystalline structure which is stable at high temperatures, or a rhombic one which is stable at low temperatures. In order to obtain a superconducting ceramic material having excellent superconducting characteristics, its crystalline structure must be completely converted from tetragonal to rhombic. With the above-described conventional process, the superconducting ceramic material is cooled at a very slow rate to perform such a convention. It is also known that a superconducting ceramic material having a twin crystalline structure is obtained when the crystalline structure is converted from tetragonal to rhombic, and that the higher the partial pressure of oxygen, the more stable the rhombic crystalline structure of worked superconducting ceramic material.

All of the R-A-Cu-O based superconducting ceramic materials, which are fabricated by the conventional process, do not have a stable superconducting characteristic. Specifically, some superconducting ceramic material having a low critical temperature and the critical current value is obtained. Some superconducting ceramic materials have a low critical current value though they have a high critical temperature and a high critical current value. Summarizing, the conventional process has a problem which is that superconducting ceramic materials having stable characteristics can not always be fabricated.

SUMMARY OF THE INVENTION

An object of the present invention is to obviate problems of the conventional processes and provide a process for efficiently constantly fabricating worked superconducting ceramic materials having a high critical current value, high critical temperature, and high critical magnetic field.

As a result of extensive investigation, the following has been determined.

(1) Characteristics of the R-A-Cu-O based superconducting ceramic such as critical temperature and critical current value can be improved by cooling with a cooling rate so as to be proportional to the square root of the temperature and partial pressure of oxygen at high temperatures higher than 300 °C after sintering.

(2) When the crystal orientations of the twin crystalline structure formed in the crystal grains of the R-A-Cu-O based sintered superconducting ceramic materials are aligned, they have a high critical magnetic field.

Therefore, the present invention provides a process for fabricating worked superconducting ceramic material composed essentially of a rare earth element from the group including yttrium, an alkaline earth metal, copper oxide, and unavoidable impurities, comprising:

(A) providing starting powder composed of:

(i) a component selected from the group consisting of:

(1) a mixed powder composed of powders of component oxides:

(1-1) a yttrium-including rare earth element oxide where the rare earth metal is selected from the group including yttrium,

(1-2) an alkaline earth metal oxide, and

(1-3) copper oxide,

and having a composition substantially the same as that of the contemplated superconducting ceramic,

(2) a mixed powder composed of powders of:

(2-1) a partial compound between any two of the component oxides constituting a contemplated superconducting ceramic selected from (1-1), (1-2) and (1-3),

and

(2-2) the remainder of the component oxides selected from

(1-1), (1-2) and (1-3),

and having a component substantially the same as that of the contemplated superconducting ceramic,

(3) powder of a superconducting ceramic composed essentially of a yttrium including rare earth element, an alkaline earth metal, copper oxide, and unavoidable impurities,

(4) a mixed powder composed of at least two members selected from the mixed powders (1), (2) and (3); and

(B) molding said starting powder to form a molded body;

(C) optionally calcining the starting powder when the starting powder is the mixed powder (i-1), (i-2) or (i-4) at a temperature sufficient for calcining the starting powder prior to or after the molding;

(D) sintering the molded body;

(E) cooling the sintered molded body at a cooling rate satisfying a relation expressed by the equation:

$$\frac{\Delta T}{\Delta t} = k \cdot T \cdot \sqrt{P_{O_2}}$$
$(0.8 \leq k \leq 1.0)$

wherein T indicates the temperature ($^\circ$C) of the sintered molded body during said cooling,

t indicates cooling period (hour),

$P_{O_2}$ indicates the partial pressure of oxygen (atm) during cooling

in a high temperature region at a temperature not lower than 300 $^\circ$C after sintering.

Hereinafter, description will be made of a typical embodiment of the present invention, in which the starting powder for fabricating superconducting ceramic material is powder of a superconducting ceramic (R-A-Cu-O) composed essentially of a rare earth element (R) from the group including yttrium, an alkaline earth metal (A), copper oxide, and unavoidable impurities.

Suitable examples of the yttrium including rare earth element which can be used include yttrium (Y), erbium (Er), dysprosium (Dy), ytterbium (Yb), gadolinium (Gd), thulium (Tm), neodymium (Nd,) (Lu), and samarium (Sm). Of these, yttrium is preferred. The yttrium-including rare earth elements can be used singly or in combination with each other.

Suitable examples of the alkaline earth metal which can be used in the present invention include barium, strontium, and calcium, with barium being preferred. The alkaline earth metal can be used singly or in combination with each other.

Powder of superconducting ceramic which can be used as a starting powder in the process of the present invention can be prepared, e.g., by calcining a mixture of single component oxides with a composition substantially the same as that of the contemplated superconducting ceramic material in an oven, e.g., electric oven at a temperature suitable for preparing ceramic, e.g., 350 $^\circ$C to 950 $^\circ$C, and grinding the resulting superconducting ceramic material to have a desired mean grain size, e.g., not greater 10 $\mu$m. Generally, smaller grain size, e.g., not greater than about 6 $\mu$m, is preferred. Of course, it is possible to use superconducting ceramic material otherwise prepared as long as it has a composition of R-A-Cu-O, e.g., $YBa_2Cu_3O_7$, to be fabricated after grinding, if desired. The superconducting ceramic powder should preferably have perovskite structure. Examples of known ceramic include those described, e.g., in Tomoji Kawai and Masaki Kanai, Japanese Journal of Applied Physics, vol.26, No. 5, May, 1987, pp.L736-L737; and Masanobu Kobayashi et al., ibid. vol.26, No.5, pp.L754-L756.

The starting powder is subjected to molding treatment such as pressing and the like to obtain a molded body in the form of pellets, films, sheets, etc, having a predetermined density. It is noted that "molding treatment" includes formation in pellets by pressing, film formation using a doctor's blade method, film formation by screen printing, and the like.

Subsequently, the molded body is sintered in an oxygen atmosphere, at a sintering temperature (Ts) of, e.g., 870 °C to 950 °C for a predetermined retention time. The sintering cannot be performed at a temperature of higher than 950 °C because a part of the molded body will melt at such temperature. The sintering must be performed at a temperature lower than 950 °C because otherwise the sintered body will at least partially fuse or melt in a high temperature region higher than 950 °C. The sintering serves to increase the density of the sintered molded body so that it can have mechanical strength.

After sintering, the sintered molded body or ceramic is cooled at a cooling rate satisfying a relation expressed by the following equation:

$$\frac{\Delta T}{\Delta t} = k \cdot T \cdot \sqrt{P_{O_2}}$$

$(0.8 \leq k \leq 1.0)$

wherein T indicates the temperature (°C) of the sintered molded body during the cooling,

t indicates cooling period (hours),

$P_{O_2}$ indicates the partial pressure of oxygen (atm) used in the cooling

in a high temperature region at a temperature of not lower than 300 °C after the sintering.

The reason why a temperature for satisfying the above equation is not lower than 300 °C is that when the temperature of the ceramic is below 300 °C, it is impossible to cool the ceramic while keeping an equilibrium relation between oxygen included in the atmosphere and oxygen diffused into compounds of the ceramic because the reaction rate between oxygen in atmosphere and the compounds, or the oxygen diffusion rate of diffusing oxygen into the compounds is very low.

From the above-mentioned reasons, temperature T in the equation must be a range of from 300 °C to 950 °C.

The reason why coefficient k in the above described equation is not more than 1.0 is that when the coefficient k is more than 1.0, the sintered molded body is cooled rapidly with a high cooling rate ΔT/Δt from a high temperature of not lower than 300 °C to room temperature to obtain a ceramic having almost no crystal grains in which twin crystalline structure is formed. Specifically, because of the rapid cooling, oxygen sufficient to be absorbed into the sintered molded body is not absorbed thereinto, and the sintered molded body is not converted from tetragonal crystalline structure being stable in high temperature region to the rhombic one being stable in a low temperature region. Further, the twin crystalline structure is rarely formed in the crystal grains of the sintered molded body because it is cooled to room temperature at a high cooling rate ΔT/Δt as described above. Accordingly, ceramic including crystal grains having numerous twin crystalline structures are rarely obtained. The obtained ceramic has low superconducting characteristic such as critical temperature, critical current value, and critical magnetic field.

On the other hand, the reason why coefficient k is not less than 0.8 is that when coefficient k is less than 0.8, the sintered molded body is cooled slowly at a low cooling rate ΔT/Δt. Accordingly, twin crystalline structure is rarely formed in the crystal grains of the sintered molded body, and the distribution of directions of growth of the twin crystalline structure are unevenly arranged during cooling. As the result, only ceramic having low critical magnetic field are obtained.

From the above-mentioned reasons, in order to obtain the ceramic including mainly crystal grains having twin crystalline structures grown in one direction, the coefficient k must be in a range of from 0.8 to 1.0.

The thus-performed cooling serves to convert the crystalline structure of the sintered molded body from tetragonal to rhombic, and to obtain a superconducting ceramic material having excellent superconducting characteristics such as high critical temperature, high critical current value, and high critical magnetic field. The cooling is preferably performed in an oxygen-rich atmosphere with high partial pressure of oxygen in order to shorten the cooling period, preferably performing at a cooling rate satisfying the equation as above-described.

After cooling, the molded body may be subjected to cold- or hot- working, e.g., swaging, rolling with grooved rolls, processing with a die, or the like, to produce a worked body having a desired shape, e.g., wire rods, plates, ribbons, strings, coils, pellets and the like. If appropriate or desired, the cold- or hot-working may be performed after molding and prior to sintering.

After working, the superconducting ceramic material may be annealed in an oxygen atmosphere with high partial pressure of oxygen, at a temperature, e.g., of 300 °C to 950 °C. The annealing serves to adjust or supplement the oxygen content of the superconducting ceramic material and/or to relax stress generated therein during working.

In another typical embodiment of the present invention, the superconducting ceramic material can be fabricated starting from a mixture of powder of a yttrium-including rare earth element oxide ($R_2O_3$), powder of an alkaline earth metal oxide (AO), and copper oxide (CuO) powder. The composition of these single component oxides are blended so that the resulting mixture has a composition substantially the same as that of the final superconducting ceramic material.

Yttrium including rare earth element oxides which can be used include oxides of the group of rare earth elements including yttrium. The same yttrium-including rare earth elements described above with respect to the preceding embodiment can also be used in the present embodiment. Of the oxides, generally yttrium oxide is preferred. The yttrium-including rare earth elements can be used singly or in combination with each other.

Examples of the alkaline earth metal oxide which can be used in the present invention include oxides of barium, strontium, and calcium. Barium oxide is preferred. The alkaline earth metal oxides can be used singly or in combination.

The single component oxides, i.e., powder of a rare earth element oxide, powder of an alkaline earth metal oxide, and copper oxide powder, each are commercially available. They can be used as they are or after having been ground in order to adjust the mean grain size to a desired size. Usually, the single component oxide powders to be used have a mean grain size of not greater than 10 $\mu$m. Generally, smaller mean grain size, e.g., not greater than 6 $\mu$m, is preferred.

The calcination of the mixed powder composition, which may be prior to or after being subjected to molding treatment, can be performed at a predetermined temperature, preferably ranging from 850 $^\circ$C to 950 $^\circ$C, more preferably from 900 $^\circ$C to 940 $^\circ$C, in air for a period sufficient to convert the mixed powder composition into a superconductive ceramic.

The same molding treatment as described with respect to the preceding embodiment can be used.

After the calcination and molding in that order or in reverse order, the resulting superconducting ceramic material may then be subjected to cold- or hot-working, which can be performed in the same manner as in the case of fabricating the superconducting ceramic material starting from superconducting ceramic powder.

The molded bodies can be sintered and cooled in the same manner as in the case of one fabricated starting from the superconducting ceramic powder.

Further, according to a variation of the above-described embodiment, powder of partial compounds between any two of the component oxides for fabricating superconducting ceramic articles, i.e., a compound between the yttrium including rare earth element and the alkaline earth metal oxide, a compound between the alkaline earth metal and copper oxide, and a compound between copper oxide and the yttrium including rare earth element, can be used together with powder of the remainder of the component oxides, i.e., copper oxide, the yttrium including rare earth element, and the alkaline earth metal, respectively, instead of using a mixture of powders of single component oxides alone as a starting powder. For example, Y-Ba-CuO based superconducting ceramic materials can be fabricated using $Y_2O_3 \cdot BaO$ and CuO in a composition substantially the same as that of the final ceramic. Other combinations, such as $CuO \cdot BaO$, and $Y_2O_3 \cdot CuO$, together with $Y_2O_3$, and BaO, respectively, can also be used. Similarly, partial compounds can be used for ceramic compositions containing other yttrium-including rare earth elements.

The partial compounds between any two of the single component oxides for fabricating superconducting ceramic material are commercially available or can be prepared in the conventional manner, e.g., by calcining a mixture of powders of any two of the single component oxides described above in an oven at temperature suitable for preparation of ceramic.

The ratio of powder of the partial compound to the remainder single component oxide which can be added is not critical as long as the resulting mixture has a composition substantially the same as that of the finally obtained superconducting ceramic material.

According to another variation, the mixed powder of the single component oxides, and/or the mixed powder of the partial compound and the remainder of the single component oxides, can be added to powder of the superconducting ceramic powder. In this case, the mixing ratio therebetween is not critical.

In the above-described variations, a superconducting ceramic material can be obtained with substantially the same operation including calcination, molding, sintering and cooling under substantially the same conditions as in the case of superconducting ceramic obtained starting from a mixture of powders of single component oxides, and detailed explanation is omitted herein.

The superconducting ceramic material may be the same as those used in the above-described embodiments of this invention, and it should preferably have a perovskite structure.

In the above-described variations, after annealing, the superconducting ceramic materials may be subjected to cooling at a cooling rate according to the present invention.

## BRIEF DESCRIPTION OF THE DRAWING

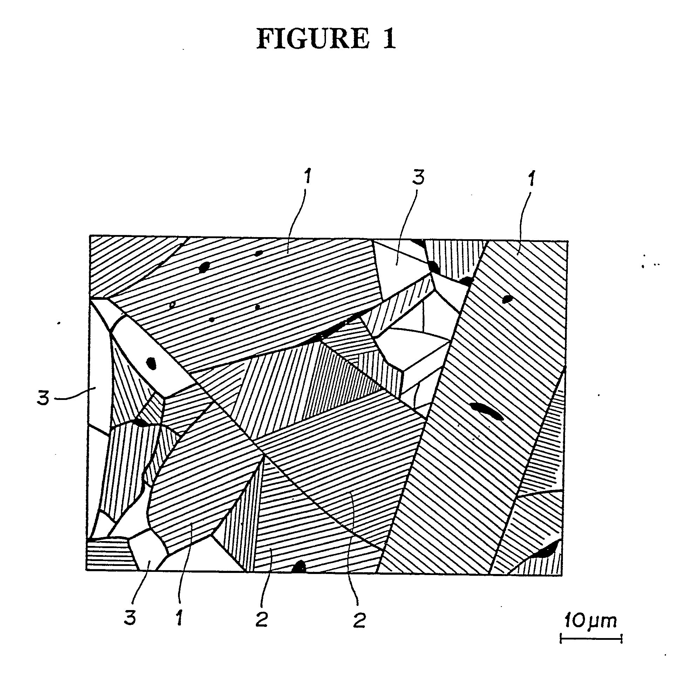

Figure 1 is a electronography showing the crystalline structure of the sintered body made of the R-A-Cu-O based superconducting ceramic material.

## DESCRIPTION OF THE INVENTION

The invention will now be explained in detail by the following examples.

## EXAMPLE

As starting material, $Y_2O_3$ powder, $BaCO_3$ powder and $CuO$ powder each having an average grain size of 6 $\mu$m were blended at a blend ratio:

$Y_2O_3 : BaCO_3 : CuO = 1/2 : 2 : 3$

and were subjected to molding. The molding was performed by pressing the blended powder at a pressure of about 1 ton/cm$^2$ to obtain a molded body. The molded body was calcined in an atmosphere of 1 atm, at a temperature of 910 $^\circ$C for a retention time of 30 hours, and then ground to obtain powder having an average grain size of 1.4 $\mu$m.

Further, the thus-obtained powders were subjected to molding to form a plurality of molded bodies in the form of pellets, each having a diameter of 20 mm and a height of 5 mm. These pellets were sintered at the temperature and oxygen atmosphere as shown in Tables 1-a and 1-b below. After sintering, the sintered bodies were cooled at a cooling rate according to the above-described equation having coefficient k as shown in Tables 2-a and 2-b. The cooling was performed so that the sintered bodies were cooled to 300 $^\circ$C.

Subsequently, the superconducting ceramic materials were subjected to annealing. The annealing was carried out in an oxygen atmosphere, at a temperature of 600 $^\circ$C for a retention time of 3 hours.

The critical temperature (Tc), critical current value (Jc) and critical magnetic field (Hc) of the superconducting ceramic materials thus obtained were measured and the results are shown in Tables 3-a and 3-b below.

For comparison, the comparative superconducting ceramic materials were prepared by the same procedures as above except different conditions for the cooling were used.

From the results shown in all of Tables, it can be seen that the superconducting ceramic materials fabricated according to the process of the present invention had Tc, Jc and Hc values much higher than those of the comparative superconducting ceramic materials.

Table 1-a

| Sintering | | |
|---|---|---|
| Invention No. | Sintering Temperature (Ts, $^\circ$C) | Partial Pressure of Oxygen ($P_{O_2}$, atm) |
| 1 | 950 | 0.2 (room air) |
| 2 | 950 | 0.2 (room air) |
| 3 | 950 | 0.2 (room air) |
| 4 | 950 | 1 |
| 5 | 950 | 1 |
| 6 | 950 | 1 |
| 7 | 950 | 10 |
| 8 | 950 | 10 |
| 9 | 950 | 10 |
| 10 | 925 | 0.2 (room air) |
| 11 | 925 | 0.2 (room air) |
| 12 | 925 | 0.2 (room air) |
| 13 | 925 | 1 |
| 14 | 925 | 1 |
| 15 | 925 | 1 |
| 16 | 925 | 10 |
| 17 | 925 | 10 |
| 18 | 925 | 10 |

Table 1-b

| Sintering | | |
|---|---|---|
| Invention No. | Sintering Temperature (Ts, $^\circ$C) | Partial Pressure of Oxygen ($P_{O_2}$, atm) |
| 19 | 900 | 0.2 (room air) |
| 20 | 900 | 0.2 (room air) |
| 21 | 900 | 0.2 (room air) |
| 22 | 900 | 1 |
| 23 | 900 | 1 |
| 24 | 900 | 1 |
| 25 | 900 | 10 |
| 26 | 900 | 10 |
| 27 | 900 | 10 |

Table 1-c

| Sintering | | |
|---|---|---|
| Comparative No. | Sintering Temperature (Ts, °C) | Partial Pressure of Oxygen ($P_{O_2}$, atm) |
| 1 | 950 | 0.2 (room air) |
| 2 | 950 | 0.2 (room air) |
| 3 | 950 | 1 |
| 4 | 950 | 1 |
| 5 | 950 | 10 |
| 6 | 950 | 10 |
| 7 | 925 | 0.2 (room air) |
| 8 | 925 | 0.2 (room air) |
| 9 | 925 | 1 |
| 10 | 925 | 1 |
| 11 | 925 | 10 |
| 12 | 925 | 10 |
| 13 | 900 | 0.2 (room air) |
| 14 | 900 | 0.2 (room air) |
| 15 | 900 | 1 |
| 16 | 900 | 1 |
| 17 | 900 | 10 |
| 18 | 900 | 10 |

Table 2-a

| Cooling | | |
|---|---|---|
| Invention No. | Coefficient k | Cooling Rate after sintering ($\Delta T/\Delta t$, °C/hr) |
| 1 | 0.8 | 332 |
| 2 | 0.9 | 374 |
| 3 | 1.0 | 415 |
| 4 | 0.8 | 744 |
| 5 | 0.9 | 837 |
| 6 | 1.0 | 930 |
| 7 | 0.8 | 2352 |
| 8 | 0.9 | 2646 |
| 9 | 1.0 | 2940 |
| 10 | 0.8 | 321 |
| 11 | 0.9 | 362 |
| 12 | 1.0 | 402 |
| 13 | 0.8 | 720 |
| 14 | 0.9 | 810 |
| 15 | 1.0 | 900 |
| 16 | 0.8 | 2276 |
| 17 | 0.9 | 2561 |
| 18 | 1.0 | 2846 |

Table 2-b

| Cooling | | |
|---|---|---|
| Invention No. | Coefficient k | Cooling Rate after sintering ($\Delta T/\Delta t$, °C/hr) |
| 19 | 0.8 | 311 |
| 20 | 0.9 | 350 |
| 21 | 1.0 | 389 |
| 22 | 0.8 | 696 |
| 23 | 0.9 | 783 |
| 24 | 1.0 | 870 |
| 25 | 0.8 | 2200 |
| 26 | 0.9 | 2476 |
| 27 | 1.0 | 2751 |

Table 2-c

| Cooling | | |
|---|---|---|
| Comparative No. | Coefficient k | Cooling Rate after sintering ($\Delta T/\Delta t$, °C/hr) |
| 1 | 0.7 | 291 |
| 2 | 1.1 | 457 |
| 3 | 0.7 | 651 |
| 4 | 1.1 | 1023 |
| 5 | 0.7 | 2058 |
| 6 | 1.1 | 3235 |
| 7 | 0.7 | 281 |
| 8 | 1.1 | 442 |
| 9 | 0.7 | 630 |
| 10 | 1.1 | 990 |
| 11 | 0.7 | 1992 |
| 12 | 1.1 | 3130 |
| 13 | 0.7 | 272 |
| 14 | 1.1 | 427 |
| 15 | 0.7 | 609 |
| 16 | 1.1 | 957 |
| 17 | 0.7 | 1925 |
| 18 | 1.1 | 3026 |

Table 3-a

| Characteristics of Superconducting Ceramic | | | |
|---|---|---|---|
| Invention No. | Critical Temperature (Tc, °K) | Critical Current (Jc, A/cm$^2$) | Critical Magnetic Field (Hc, T) |
| 1 | 96 | 3350 | >10 |
| 2 | 96 | 3300 | >10 |
| 3 | 96 | 3200 | >10 |
| 4 | 96 | 2800 | >10 |
| 5 | 96 | 2750 | >10 |
| 6 | 96 | 2700 | >10 |
| 7 | 95 | 2500 | >10 |
| 8 | 95 | 2450 | >10 |
| 9 | 95 | 2400 | >10 |
| 10 | 96 | 2700 | ~10 |
| 11 | 96 | 2650 | ~10 |
| 12 | 96 | 2600 | ~10 |
| 13 | 95 | 2400 | >10 |
| 14 | 95 | 2330 | >10 |
| 15 | 95 | 2300 | >10 |
| 16 | 95 | 2450 | >10 |
| 17 | 95 | 2400 | >10 |
| 18 | 95 | 2400 | >10 |

Table 3-b

| Characteristics of Superconducting Ceramic | | | |
|---|---|---|---|
| Invention No. | Critical Temperature (Tc, °K) | Critical Current (Jc, A/cm2) | Critical Magnetic Field (Hc, T) |
| 19 | 95 | 1750 | ~8 |
| 20 | 95 | 1720 | ~8 |
| 21 | 95 | 1700 | ~8 |
| 22 | 96 | 1950 | ~10 |
| 23 | 96 | 1920 | ~10 |
| 24 | 96 | 1900 | ~10 |
| 25 | 95 | 2220 | ~10 |
| 26 | 95 | 2150 | ~10 |
| 27 | 95 | 2100 | ~10 |

Table 3-c

| Characteristics of Superconducting Ceramic | | | |
|---|---|---|---|
| Comparative No. | Critical Temperature (Tc, °K) | Critical Current (Jc, A/cm²) | Critical Magnetic Field (Hc, T) |
| 1 | 96 | 3100 | ~5 |
| 2 | 90 | 2500 | ~2 |
| 3 | 96 | 2000 | ~6 |
| 4 | 90 | 2500 | ~2 |
| 5 | 95 | 2550 | ~5 |
| 6 | 86 | 1800 | ~3 |
| 7 | 96 | 2750 | ~7 |
| 8 | 90 | 1800 | ~2 |
| 9 | 95 | 2440 | ~9 |
| 10 | 88 | 1800 | ~5 |
| 11 | 95 | 2500 | ~7 |
| 12 | 85 | 1500 | ~2 |
| 13 | 95 | 1800 | ~6 |
| 14 | 89 | 900 | ~2 |
| 15 | 95 | 1970 | ~8 |
| 16 | 90 | 1000 | ~3 |
| 17 | 95 | 2230 | ~9 |
| 18 | 89 | 1600 | ~3 |

Further, a relation between the twin crystalline structure in the crystal grains of the superconducting ceramic and the critical magnetic fields thereof will now be explained as follows.

Figure 1 is a sectional view of the crystalline structure of the sintered body made of R-A-Cu-O based superconducting observed by scanning electron microscope. Referring to Figure 1, numeral 1 denotes crystal grains each having twin crystalline structures grown in one direction, numeral 2 denotes crystal grains each having twin crystalline structures grown in various directions, and numeral 3 denotes crystal grains each having no twin crystalline structure.

As to the crystal grains 1, 2, and 3, critical magnetic fields thereof were measured. The results showed that as more twin crystalline structure was formed in the crystal grains of the sintered body, the greater the Hc value obtained thereof. Furthermore, it was seen that the Hc value of the crystal grain 1 was better than that of the crystal grain 2, and that Hc value of the crystal grain 3 was very low.

## Claims

1. A process for fabricating superconducting ceramic material composed essentially of a yttrium including rare earth element, an alkaline earth metal, copper oxide, and unavoidable impurities, comprising:
(A) providing starting powder composed of:
(i) a component selected from the group consisting of:
(1) a mixed powder composed of powders of component oxides:
(1-1) a yttrium including rare earth element oxide,
(1-2) an alkaline earth metal oxide, and
(1-3) copper oxide,
and having a composition substantially the same as that of the contemplated superconducting ceramic,
(2) a mixed powder composed of powders of:
(2-1) a partial compound between any two of the component oxides constituting a contemplated superconducting ceramic selected from (1-1), (1-2) and (1-3),
and
(2-2) the remainder of the component oxides selected from
(1-1), (1-2) and (1-3),

and having a component substantially the same as that of the contemplated superconducting ceramic,
(3) powder of a superconducting ceramic composed essentially of a yttrium including rare earth element, an alkaline earth metal, copper oxide, and unavoidable impurities,
(4) a mixed powder composed of at least two members selected from the mixed powders (1), (2) and (3); and

(B) molding said starting powder to form a molded body;
(C) optionally calcining said starting powder when said starting powder is said mixed powder (i-1), (i-2) or (i-4) at a temperature sufficient for calcining said starting powder prior to or after said molding;
(D) sintering said molded body;
(E) cooling said sintered molded body at a cooling rate satisfying a relation expressed by the equation:

$$\frac{\Delta T}{\Delta t} = k \cdot T \cdot \sqrt{P_{O_2}}$$
$$(0.8 \leq k \leq 1.0)$$

wherein T indicates the temperature ($^\circ$C) of the sintered molded body during said cooling,
t indicates cooling period (hour),
$P_{O_2}$ indicates the partial pressure of oxygen (atm) during said cooling
in a high temperature region at a temperature not lower than 300 $^\circ$C after said sintering.

2. The process as claimed in Claim 1, wherein said starting powder is composed of the mixed powder (1) and/or (2) and/or (4).

3. The process as claimed in Claim 1, wherein said starting powder is composed of the mixed powder (1) and/or (2) and/or (3).

4. The process as claimed in Claim 2 or 3, wherein said yttrium including rare earth element oxide (1-1) is yttrium oxide.

5. The process as claimed in Claim 4, wherein said alkaline earth metal oxide (1-2) is barium oxide.

6. The process as claimed in Claim 2 or 3, wherein said yttrium including rare earth element is yttrium.

7. The process as claimed in Claim 6, wherein said alkaline earth metal is barium.

8. The process as claimed in Claim 1, further comprising introducing said starting powder into a metal casing made of a metal selected from the group consisting of copper, silver, and aluminum, and alloys thereof.

9. The process as claimed in Claim 1, further comprising annealing said sintered molded body in an oxygen atmosphere after said cooling.

# FIGURE 1

10 μm